# EUROPÄISCHE PATENTANMELDUNG

(11) **EP 1 595 968 A1**
(43) Veröffentlichungstag der Anmeldung: **16.11.2005**
(21) Anmeldenummer: 04010317.8
(22) Anmeldetag: 30.04.2004
(51) Int. Cl.: C22F 1/10, C21D 9/00

(54) **Wärmebehandlungsverfahren für einkristalline oder direktional verfestigte Bauteile**

(71) Anmelder: SIEMENS AKTIENGESELLSCHAFT, 80333 München (DE)
(72) Erfinder: Ott, Michael, Dr., 45478 Mülheim (DE); Paul, Uwe, Dr., 40882 Rattingen (DE)

(57) **Zusammenfassung**

Ein erfindungsgemäßes Wärmebehandlungsverfahren für einkristalline oder direktional verfestigte Bauteile (1) umfasst eine Wärmebehandlung, die zu einem Lösen mindestens einer kristallinen Phase des Materials des Bauteils (1), im folgenden Bauteilmaterial genannt, führt. Das Verfahren zeichnet sich dadurch aus, dass bei der Wärmebehandlung ein Heizen des Bauteils (1) auf ein zum Lösen der kristallinen Phase notwendige Lösungstemperatur nur in mindestens einem ersten Bauteilbereich (2, 4) erfolgt, in welchem Spannungen im Bauteilmaterial höchstens ein bestimmtes Maß aufweisen. In mindestens einem zweiten Bauteilbereich (3), in welchem Spannungen im Bauteilmaterial das bestimmte Maß überschreiten, erfolgt dagegen lediglich ein Heizen auf eine Temperatur unterhalb der Lösungstemperatur.

## Beschreibung

Die vorliegende Erfindung betrifft ein Wärmebehandlungsverfahren für einkristalline oder direktional verfestigte Bauteile, welches zum Lösen mindestens einer kristallinen Phase des Bauteils führt.

Beispielsweise Turbinenbauteile, wie etwa Turbinenschaufeln, werden u.a. aus Superlegierungen hergestellt. Superlegierungen sind Legierungen auf Nickel- oder Kobaltbasis und umfassen typischerweise Chrom, Titan, Tantal, Aluminium, Wolfram und weitere Elemente mit ausgezeichneter Resistenz gegen hohe Temperaturen und gleichzeitig hoher Festigkeit. Ein Beispiel für eine aus einer Superlegierung hergestellt Gasturbinenschaufel ist der US 5,611,670 zu entnehmen.

Das Superlegierungsmaterial weist eine kristalline Struktur auf. Wie in anderen kristallinen Strukturen können auch in Superlegierungsmaterialien Kristallfehler auftreten. Ein typischer Kristallfehler sind Korngrenzen, d.h. Grenzen zwischen verschiedenen Materialbereichen, die zwar dieselbe kristalline Struktur, jedoch eine verschiedene kristallographische Orientierung aufweisen. In direktional verfestigten Bauteilen erstrecken sich die Korngrenzen im Material im Wesentlichen lediglich in eine Richtung, beispielsweise in Radialrichtung der Turbinenschaufel. In einkristallinen Materialien sind dagegen im Wesentlichen keine Korngrenzen vorhanden.

Bauteile aus einer Superlegierung, wie die genannten Turbinenschaufeln, werden gegossen und nach dem Gießen weiteren Bearbeitungsschritten unterzogen. Die weiteren Bearbeitungsschritte umfassen dabei eine Wärmebehandlung zum homogenisieren des Materials, eine so genannte Lösungswärmebehandlung, die u.a. zu einer Erhöhung der Festigkeit der Turbinenschaufel führt. Darüber hinaus werden die gegossenen Turbinenschaufeln auch mechanischen Bearbeitungen unterzogen. Die mechanischen Bearbeitungen führen dabei zu Spannungen im Material der Bauteile, welche während einer Lösungswärmebehandlung zur Bildung von neuen Körnern (Rekristallisation) und somit zu Korngrenzen führen können. Diese Körner verschlechtern die Materialeigenschaften von einkristallinen oder direktional verfestigten Bauteilen und haben infolge dessen einen negativen Einfluss auf die Lebensdauer des Bauteils. Um dies zu vermeiden, werden die frisch gegossenen Bauteile unmittelbar nach dem Gießprozess und dem teilweise Entfernen der Gießform bereits der Wärmebehandlung unter Schutzgasatmosphäre oder unter Vakuum unterzogen. Erst danach werden die mechanischen Bearbeitungen des Bauteils ausgeführt.

Falls neue Bauteile nachgearbeitet werden müssen oder bereits in Betrieb befindliche Bauteile repariert werden müssen, beispielsweise durch Schweißen oder Löten, kann dies eine erneute Wärmebehandlung bei der Temperatur der Lösungswärmebehandlung oder in der Nähe dieser Temperatur erforderlich machen. Aufgrund der von dem mechanischen Bearbeiten nach dem Gießprozess noch vorhandenen Spannungen kann dies zur Bildung von rekristallisierten Körnern führen. Andererseits kann eine Lösungswärmebehandlung insbesondere bei Bauteilen, die bereits eine bestimmte Betriebsdauer hinter sich haben, die Lebensdauer der Bauteile erhöhen.

Aufgabe der vorliegenden Erfindung ist es daher, ein Wärmebehandlungsverfahren zur Verfügung zu stellen, welches sich vorteilhaft auf das Materialgefüge eines Bauteils auswirkt und in dem gleichzeitig das Bilden von rekristallisierten Körnern im Vergleich zu den Verfahren nach Stand der Technik vermindert ist.

Diese Aufgabe wird durch ein Wärmebehandlungsverfahren nach Anspruch 1 gelöst. Die abhängigen Ansprüche enthalten vorteilhafte Weiterbildungen des erfindungsgemäßen Wärmebehandlungsverfahrens.

Ein erfindungsgemäßes Wärmebehandlungsverfahren für einkristalline oder direktional verfestigte Bauteile umfasst eine Wärmebehandlung, die zu einem Lösen mindestens einer kristallinen Phase des Materials des Bauteils, im folgenden Bauteilmaterial genannt, führt. Das Verfahren zeichnet sich dadurch aus, dass bei der Wärmebehandlung ein Heizen des Bauteils auf ein zum Lösen der kristallinen Phase notwendige Lösungstemperatur in mindestens einem ersten Bauteilbereich erfolgt. In mindestens einem zweiten Bauteilbereich erfolgt dagegen lediglich ein Heizen auf eine Temperatur unterhalb der Lösungstemperatur.

Das erfindungsgemäße Wärmebehandlungsverfahren für einkristalline oder direktional verfestigte Bauteile umfasst eine Wärmebehandlung, die zu einem Lösen mindestens einer kristallinen Phase des Materials des Bauteils, im folgenden Bauteilmaterial genannt, führt. Das Verfahren zeichnet sich besonders bei bestimmten Bauteilen dadurch aus, dass bei der Wärmebehandlung ein Heizen des Bauteils auf ein zum Lösen der kristallinen Phase notwendige Lösungstemperatur nur in mindestens einem ersten Bauteilbereich erfolgt, in welchem Spannungen im Bauteilmaterial höchstens ein bestimmtes Maß aufweisen. In mindestens einem zweiten Bauteilbereich, in welchem Spannungen im Bauteilmaterial das bestimmte Maß überschreiten, erfolgt dagegen lediglich ein Heizen auf eine Temperatur unterhalb der Lösungstemperatur.

Das erfindungsgemäße Verfahren bietet die Möglichkeit auch solche Bauteile der Lösungswärmebehandlung zu unterziehen, die in Teilbereichen hohe Spannungen und in anderen Bereichen niedrige Spannungen ausweisen. Beispielsweise weist der bearbeitete Schaufelfuß von einkristallinen oder direktional verfestigten Turbinenschaufeln große innere Spannungen auf, die vom Schleifen des Schaufelfußes und/oder von einem Kugelstrahlprozess zum Bearbeiten des Schaufelfußes stammen. Andererseits treten im Schaufelfuß aufgrund seiner geschützten Lage während des Betriebs der Turbine fast keine Verschlechterungen der Mikrostruktur der Superlegierung und häufig auch keine wesentlichen Beschädigungen auf. Es sind daher in der Regel auch keine Reparaturen am Schaufelfuß notwendig. Eine Lösungswärmebehandlung zum Rekonditionieren des Bauteilmaterials, d.h. zum Beseitigen von Alterserscheinungen im Material, ist daher im Bereich des Schaufelfußes nicht nötig. Mit dem erfindungsgemäßen Verfahren kann die Wärmebehandlung daher auf den Bereich des Schaufelblattes und der Schaufelbasis, an denen aufgrund des Betriebs der Turbine ein höherer Materialverschleiß als am Schaufelfuß stattgefunden hat, beschränkt werden. Die Temperatur des Schaufelfußes während der Wärmebehandlung wird dabei durch geeignete Maßnahmen in einem Bereich unterhalb der Lösungstemperatur gehalten.

Das Heizen des Bauteils während der erfindungsgemäßen Wärmebehandlung kann insbesondere mittels Induktionsheizens erfolgen. Um dabei einen Temperaturgradienten, d.h. unterschiedliche Temperaturen für erste und zweite Bauteilbereiche zu erzeugen, finden für erste und zweite Bauteilbereiche verschiedene Induktionsheizspulen Verwendung. Das induktive Heizen des Bauteils ermöglicht es, zuerst eine flache Oberflächenschicht zu erheizen und so die Spannungen in der Oberfläche unter einen Wert zu reduzieren, der zum Auslösen der Kornbildung (Rekristallisation) führt.

Alternativ kann das Heizen des Bauteils im erfindungsgemäßen Wärmebehandlungsverfahren auch mittels strahlender Energiequellen, bspw. Lampen, erfolgen. Für erste und zweite Bauteilbereiche finden dann Energiequellen (Lampen) mit verschiedener Strahlungsleistung Verwendung. Die unterschiedliche Strahlungsleistung kann dabei auch durch verschiedene Einstellungen von an sich gleichen Energiequellen (Lampen) realisiert sein. Das Heizen mittels strahlender Energiequellen und insbesondere mittels Lampen hat den Vorteil, dass der Heizprozess weniger empfindlich auf die beim Heizen verwendete Atmosphäre reagiert insbesondere dann, wenn diese Atmosphäre eine oxidierende Atmosphäre ist.

In einer dritten Möglichkeit zum Heizen des Bauteils während der erfindungsgemäßen Wärmebehandlung kann das gesamte Bauteil derselben Wärmequelle ausgesetzt werden. In diesem Fall werden die zweiten Bauteilbereiche gekühlt, oder sie sind isoliert, um die Wärmezufuhr zu den zweiten Bauteilbereichen zu verringern. Das Kühlen oder Isolieren von Bauteilbereichen eignet sich insbesondere zur Umgestaltung von bereits existierenden Wärmebehandlungsverfahren, in denen die Bauteile ein und derselben Wärmequelle ausgesetzt werden, in ein erfindungsgemäßes Wärmebehandlungsverfahren.

In einer Weiterbildung des erfindungsgemäßen Wärmebehandlungsverfahrens erfolgt die Wärmebehandlung unter dem Einfluss einer oxidierenden Atmosphäre. Die oxidierende Atmosphäre sorgt dann beim Heizen des Bauteils für die Bildung einer Oxidschicht auf der Oberfläche, die als eine die Neigung zur Bildung von rekristallisierten Körnern herabsetzende Schutzschicht dient. Das Verwenden einer oxidierenden Atmosphäre ist beispielsweise in der US 2003/0062099 beschrieben, auf deren Offenbarung in diesem Zusammenhang verwiesen wird. Der Schutz durch die oxidierende Atmosphäre wirkt sich dabei insbesondere auf diejenigen Bereiche aus, in denen die Lösungstemperatur erreicht oder überschritten wird.

In einer besonderen Ausgestaltung ist das erfindungemäße Wärmebehandlungsverfahren als ein Wärmebehandlungsverfahren zum Wärmebehandeln einer Turbinenschaufel ausgestaltet. Ein Heizen der Turbinenschaufel auf eine zum Lösen der kristallinen Phase notwendige Lösungstemperatur erfolgt dann lediglich im Bereich des Schaufelblattes und der Schaufelbasis. Im Bereich des Schaufelfußes erfolgt dagegen lediglich ein Heizen auf eine Temperatur unterhalb der Lösungstemperatur. Diese Ausgestaltung beruht auf der Erkenntnis, dass der Schaufelfuß im Vergleich zur Schaufelbasis und zum Schaufelblatt hohe innere Spannungen, aber nur eine geringe betriebsbedingte Verschlechterung der Mikrostruktur aufweist. Mit anderen Worten, der Schaufelfuß, in welchem hohe innere Spannungen vorliegen und in dem daher die Tendenz zum Bilden von rekristallisierten Körnern groß ist, in welchem andererseits aber die Notwendigkeit zum Durchführen einer Lösungswärmebehandlung aufgrund der kaum verschlechterten Materialeigenschaften gering ist, wird keiner Lösungswärmebehandlung unterzogen. Das Schaufelblatt und die Schaufelbasis, in denen die Spannungen deutlich geringer sind, als im Schaufelfuß, und bei denen eine Beseitigung von Alterserscheinungen des Materials wünschenswert ist, erfolgt dagegen eine Lösungswärmebehandlung.

Das Wärmebehandlungsverfahren für eine Turbinenschaufel eignet sich insbesondere für Turbinenschaufeln, die aus einer Superlegierung hergestellt sind, welche eine kristalline γ-Phase und eine kristalline γ'-Phase umfassen. Das Heizen des Schaufelblattes und der Schaufelbasis erfolgt dann mindestens auf eine zum Lösen der γ'-Phase notwendigen Temperatur.

Das Wärmebehandlungsverfahren für Turbinenschaufeln kann insbesondere als Teil eines Wiederaufbereitungs- und/oder Reparaturverfahrens für Turbinenschaufeln ausgestaltet sein.

Weitere Merkmale, Eigenschaften und Vorteile der vorliegenden Erfindung ergeben sich aus der nachfolgenden Beschreibung eines Ausführungsbeispiels unter Bezugnahme auf die beiliegenden Figuren.

Figur 1 zeigt eine Turbinenschaufel während der Durchführung des erfindungsgemäßen Wärmebehandlungsverfahrens.

Figur 2 zeigt in einer schematischen Darstellung die Struktur des Materials, aus welchem die in Figur 1 dargestellte Turbinenschaufel hergestellt ist.

Figur 3 zeigt Korngrenzen in einem Material, wie es in Fig. 2 dargestellt ist.

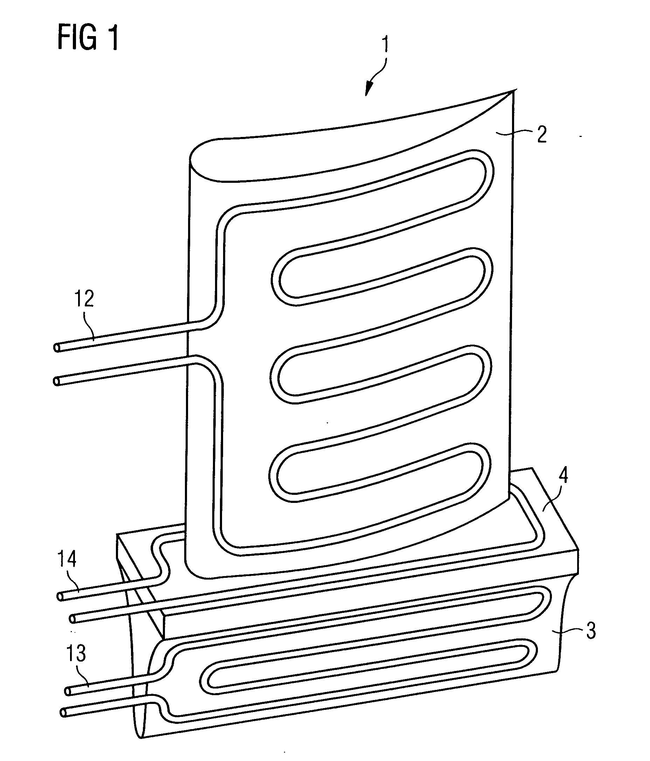

In Figur 1 ist eine Turbinenschaufel 1 während des Durchführens des erfindungsgemäßen Wärmebehandlungsverfahrens dargestellt. Die Turbinenschaufel 1 umfasst ein Schaufelblatt 2, einen Schaufelfuß 3 sowie eine Schaufelbasis 4, welche das Schaufelblatt 2 mit dem Schaufelfuß 3 verbindet. Die Turbinenschaufel ist aus einer einkristallinen Superlegierung auf Nickelbasis hergestellt, welche eine einkristalline Struktur mit zwei kristallinen Hauptphasen, der so genannten γ- Phase und der so genannten γ'-Phase aufweist. Beide Phasen sind einem Fachmann wohl bekannt und werden an dieser Stelle nicht weiter erläutert.

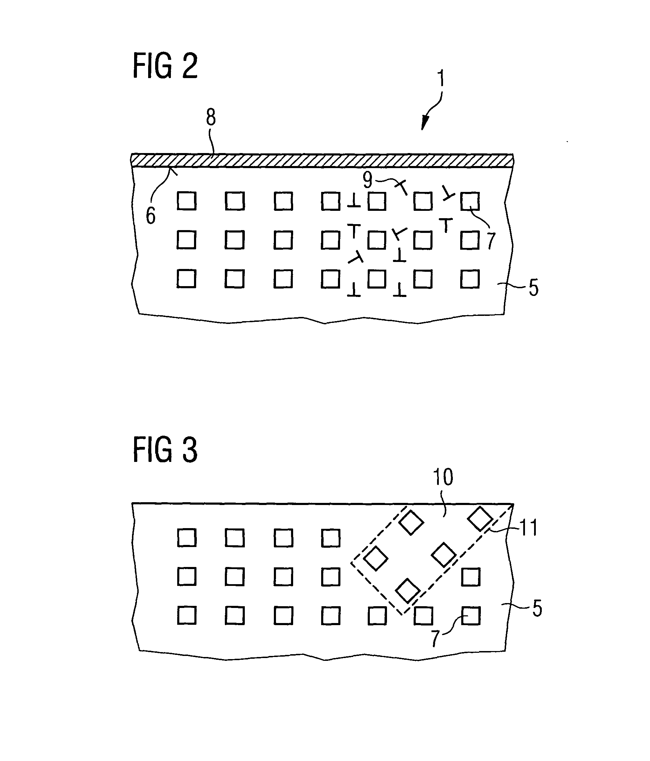

Die Struktur der einkristallinen Superlegierung auf Nickelbasis ist in Figur 2 schematisch dargestellt. Es ist die Mikrostruktur des Materials mit der γ-Phase 5 und der γ'-Phase 7 zu erkennen. Ebenfalls dargestellt sind Stellen des Materials, an denen Gitterfehler vorliegen, so genannte Fehlstellen 9. Derartige Fehlstellen 9 bilden sich aufgrund von Spannungen, die in der Superlegierung während des mechanischen Bearbeitens der Turbinenschaufel 1 entstehen. Besonders viele dieser Fehlstellen 9 liegen dabei im Schaufelfuß 3 vor, da dieser nach dem Gießen einer mechanischen Bearbeitung mittels eines Schleifverfahrens und /oder mittels eines Kugelstrahlverfahrens unterzogen wird und dabei starke Verformungen im Schaufelfuß 3 - insbesondere in Oberflächennähe - auftreten. Eine Wärmebehandlung in einem Bereich mit einer hohen Dichte an Fehlstellen würde jedoch zu einer Rekristallisation des Material führen und so fehlorientierte Körner 10 und Korngrenzen 11 im Material verursachen (siehe Fig. 3).

Im Gegensatz zum Schaufelfuß 3 weisen die Schaufelbasis 4 sowie das Schaufelblatt 2 deutlich weniger Fehlstellen 9 auf, so dass es bei einer Lösungswärmebehandlung zu einer deutlich geringeren Bildung von rekristallisierten Körnern - und damit zu weniger Korngrenzen - kommt.

Während des Wärmebehandlungsverfahrens werden das Schaufelblatt 2 und die Schaufelbasis 4 auf eine Lösungstemperatur geheizt, die dazu führt, dass sich zumindest die γ'-Phase 7 der Superlegierung auflöst. Der Schaufelfuß 3 wird dagegen lediglich auf eine Temperatur unterhalb der Lösungstemperatur erwärmt. Im vorliegenden Ausführungsbeispiel wird der Temperaturgradient zwischen Schaufelblatt 2 und Schaufelbasis 4 einerseits und dem Schaufelfuß 3 andererseits dadurch erzeugt, dass die Turbinenschaufel 1 mittels Induktionsheizung geheizt wird, wobei getrennte Induktionsheizspulen 12, 13, 14 für Schaufelblatt 2, Schaufelfuß 3 bzw. Schaufelbasis 4 Verwendung finden, welche unterschiedlich betrieben werden (Fig. 1). Im vorliegenden Ausführungsbeispiel könnten die Schaufelbasis 4 und das Schaufelblatt 2 auch mit einer einzigen gemeinsamen Induktionsheizspule geheizt werden, da diese beiden Abschnitte der Turbinenschaufel 1 jeweils auf oder über die Lösungstemperatur für die γ'-Phase 7 geheizt werden.

Statt des Induktionsheizens kann auch ein Heizen mittels Heizstrahlern erfolgen. In diesem Fall sind Schaufelblatt 2, Schaufelbasis 4 und Schaufelfuß 3 jeweils eigene Heizstrahler zugeordnet, die entweder unterschiedlich betrieben werden oder einen unterschiedlichen Aufbau besitzen, so dass sie im Ergebnis mit unterschiedlicher Leistung abstrahlen.

Schließlich ist es auch möglich, die Turbinenschaufel so zu erwärmen, dass Schaufelblatt 2, Schaufelfuß 3 und Schaufelbasis 4 derselben Wärmequelle ausgesetzt sind. In diesem Fall wird der Schaufelfuß 3 mit einer Kühlvorrichtung oder einer thermischen Isolation versehen, um die Wärmeaufnahme durch den Schaufelfuß 3 im Vergleich zur Wärmeaufnahme durch das Schaufelblatt 2 und die Schaufelbasis 4 soweit zu verringern, dass die Lösungstemperatur für die γ'-Phase nicht erreicht wird.

Auf das Erreichen der Lösungstemperatur für die γ'-Phase im Schaufelfuß 3 kann deshalb verzichtet werden, weil am Schaufelfuß 3 in der Regel keine Reparaturen notwendig sind, die eine anschließende Lösungswärmebehandlung nötig machen. Im Schaufelblatt 2 bzw. an der Schaufelbasis 4 sind derartige Reparaturen jedoch deutlich häufiger nötig, da diese beim Betrieb der Gasturbine einen sehr viel stärkeren Verschleiß erfahren und dementsprechend häufig geschweißt oder gelötet werden müssen. Schweiß- und/oder Lötverfahren machen jedoch in der Regel eine anschließende Lösungswärmebehandlung erforderlich.

In einer vorteilhaften Weiterbildung kann die Wärmebehandlung der Turbinenschaufel 1 in einer oxidierenden Atmosphäre stattfinden. Als oxidierende Atmosphäre kann im einfachsten Fall Luft Verwendung finden. Das Durchführen der Wärmebehandlung in einer oxidierenden Atmosphäre führt dann dazu, dass sich an der Oberfläche 6 des Turbinenbauteils 1 eine Oxidschicht 8 bildet, welche die Formierung von Körnern und Korngrenzen unterdrückt. Das Durchführen der Wärmebehandlung in einer oxidierenden Atmosphäre und die Auswirkungen der oxidierenden Atmosphäre sind in US 2003/0062099 A1 im Detail beschrieben. Auf diese Druckschrift wird daher bezüglich weiterer Details der Wärmbehandlung in einer oxidierenden Atmosphäre verwiesen.

Das vorgestellte Wärmebehandlungsverfahren ermöglicht es, ein Wiederaufarbeiten (Verjüngen, engl. "rejuvenation") an gebrauchten kristallinen oder direktional verfestigten Bauteilen durchzuführen. Das Reparieren entweder von neuen Bauteilen oder von Bauteilen, die bereits im Betrieb gestanden haben, mit Verfahren, die eine anschließende Lösungswärmebehandlung erfordern, beispielsweise Löten oder Schweißen, werden ebenso ermöglicht.

## Patentansprüche

1. Wärmebehandlungsverfahren zum Wärmebehandeln eines einkristallinen oder direktional verfestigten Bauteils, welches eine Wärmebehandlung umfasst, die zu einem Lösen mindestens einer kristallinen Phase des Bauteilmaterials führt,
**dadurch gekennzeichnet,**
**dass** bei der Wärmebehandlung ein Heizen des Bauteils (1) auf oder über eine zum Lösen der kristallinen Phase notwendige Lösungstemperatur nur in mindestens einem ersten Bauteilbereich (2,4) erfolgt und
**dass** in mindestens einem zweiten Bauteilbereich (3), lediglich ein Heizen auf eine Temperatur unterhalb der Lösungstemperatur erfolgt.

2. Wärmebehandlungsverfahren nach Anspruch 1,
**dadurch gekennzeichnet,**
**dass** bei der Wärmebehandlung ein Heizen des Bauteils (1) auf oder über eine zum Lösen der kristallinen Phase notwendige Lösungstemperatur nur in mindestens einem ersten Bauteilbereich (2,4) erfolgt,
in dem Spannungen im Bauteilmaterial höchstens ein bestimmtes Maß aufweisen, und
**dass** in mindestens einem zweiten Bauteilbereich (3), in denen Spannungen im Bauteilmaterial das bestimmte Maß überschreiten, lediglich ein Heizen auf eine Temperatur unterhalb der Lösungstemperatur erfolgt. -

3. Wärmebehandlungsverfahren nach Anspruch 1,
**dadurch gekennzeichnet,**
**dass** das Heizen des Bauteils mittels Induktionsheizen erfolgt, wobei für erste und zweite Bauteilbereiche verschiedene Induktionsheizspulen Verwendung finden.

4. Wärmebehandlungsverfahren nach Anspruch 1,
**dadurch gekennzeichnet,**
**dass** das Heizen des Bauteils mittels strahlender Energiequellen erfolgt, wobei für erste und zweite Bauteilbereiche Energiequellen mit unterschiedlicher Strahlungsleistung Verwendung finden.

5. Wärmebehandlungsverfahren nach Anspruch 1,
**dadurch gekennzeichnet,**
**dass** das erste und die zweite Bauteilbereiche (2, 3, 4) derselben Wärmequelle ausgesetzt werden und zweite Bauteilbereiche (3) gekühlt werden oder isoliert sind.

6. Wärmebehandlungsverfahren nach einem der vorangehenden Ansprüche,
**dadurch gekennzeichnet,**
**dass** die Wärmebehandlung unter dem Einfluss einer oxidierenden Atmosphäre erfolgt.

7. Wärmebehandlungsverfahren nach einem der vorangehenden Ansprüche,
**dadurch gekennzeichnet,**
**dass** es als Wärmebehandlungsverfahren zum Wärmebehandeln einer Turbinenschaufel(1) ausgestaltet ist, in dem ein Heizen der Turbinenschaufel(1) auf eine zum Lösen der kristallinen Phase notwendige Lösungstemperatur nur im Bereich des Schaufelblattes (2) und der Schaufelbasis (4) erfolgt, und im Bereich des Schaufelfußes (3) lediglich ein Heizen auf eine Temperatur unterhalb Lösungstemperatur erfolgt.

8. Wärmebehandlungsverfahren nach Anspruch 7,
**dadurch gekennzeichnet,**
**dass** die Turbinenschaufel aus einer Superlegierung hergestellt ist, die eine kristalline γ-Phase und eine kristalline γ'-Phase umfasst und dass das Wärmebehandlungsverfahren ein Heizen des Schaufelblattes (2) und der Schaufelbasis (4) mindestens auf eine zum Lösen der kristallinen γ'-Phase notwendige Temperatur beinhaltet.

9. Wärmebehandlungsverfahren nach Anspruch 7 oder Anspruch 8, **gekennzeichnet durch** seine Ausgestaltung als Teil eines Wiederaufbereitungsverfahrens und/oder Reparaturverfahrens für eine Turbinenschaufel.
